# EUROPEAN PATENT SPECIFICATION

(11) **EP 2 448 012 B1**
(45) Date of publication and mention of the grant of the patent: **18.12.2013**
(21) Application number: 10791759.3
(22) Date of filing: 01.02.2010
(51) Int. Cl.: H01L 31/10, G02F 1/1333, G02F 1/135, H01L 27/146

(54) **Method of operating a PHOTOTRANSISTOR, AND A DISPLAYING DEVICE EQUIPPED THEREWITH**
Verfahren zum betreiben einen FOTOTRANSISTOR UND DAMIT AUSGESTATTETE ANZEIGEVORRICHTUNG
Procédé de fonctionnement d'un PHOTOTRANSISTOR, ET AFFICHEUR ÉQUIPÉ DE CE PHOTOTRANSISTOR

(30) Priority: 26.06.2009 JP 2009152797
(43) Date of publication of application: 02.05.2012
(73) Proprietor: Sharp Kabushiki Kaisha, Osaka-shi, Osaka 545-8522 (JP)
(72) Inventor: KITAGAWA, Hideki, Osaka-shi, Osaka 545-8522 (JP); IMAI, Hajime, Osaka-shi, Osaka 545-8522 (JP); MURAI, Atsuhito, Osaka-shi, Osaka 545-8522 (JP)
(74) Representative: Hoffmann, Jörg Peter
(86) International application number: PCT/JP2010/000578
(87) International publication number: WO 2010/150431

(56) References cited:
- JP-A- 6 132 560
- JP-A- 2001 086 293
- JP-A- 2002 259 955
- JP-A- 2006 013 407
- JP-A- 2007 250 252
- US-A1- 2008 142 920

## Description

### TECHNICAL FIELD

The present invention relates to a phototransistor and a display device including the phototransistor.

### BACKGROUND ART

In recent years, attention has been given to touch panel devices as input means for devices. A resistive layer type, an optical type, etc., are generally known as types of the touch panel devices. For example, layering the touch panel devices on a liquid crystal display panel to provide a liquid crystal display device with a touch panel had been known. However, the problem in this technique was that the thickness of the display device was increased. To reduce the thickness of the device as a whole, providing a plurality of optical sensors to the liquid crystal display panel so that the liquid crystal display panel itself has a function of a touch panel has been known. The optical sensors are, for example, phototransistors. Document US 2008/142920 describes a phototransitor.

In the liquid crystal display panel which has a function of a touch panel, a current flows in the optical sensors in the area where light is not blocked, whereas no current flows in the optical sensors in the area where light is blocked by the contact of an object such as a finger of the user. This is how the contact location (i.e., a touch location) is detected.

However, characteristics of the optical sensors, such as phototransistors, may deteriorate with time and use, which may result in a reduction in sensitivity of the sensors.

Patent Document 1 discloses a liquid crystal display device which includes a backlight and a light source for adjusting brightness. Brightness of light emitted from the backlight, and brightness of light emitted from the light source for adjusting brightness, are separately detected to obtain ratios between the brightness of light of the light sources. Based on comparison between the brightness ratios, a current value of drive current to be supplied to the backlight is adjusted (corrected), thereby controlling the brightness of light. Therefore, even if light-emitting characteristics of the backlight, or light-receiving characteristics of the optical sensors are deteriorated, brightness of the display light is properly maintained. Patent Document 2 discloses an image reader having a so-called double gate phototransistor, wherein a pulse voltage is applied to a top gate electrode in a reset operation, and a high level bias voltage is applied to a bottom gate electrode in a readout operation.

### CITATION LIST

### PATENT DOCUMENT

Patent Document 1: Japanese Patent Publication No. 2007-250252
Patent Document 2: Japanese Patent Publication No. 2002-259955

### SUMMARY OF THE INVENTION

### TECHNICAL PROBLEM

However, in Patent Documents 1 and 2, no measure is taken to reduce age deterioration of light-receiving characteristics of the optical sensors.

Thus, the liquid crystal display device disclosed in Patent Document 1 has a problem that another light source for adjusting brightness is needed to properly maintain the brightness of the display light. Further, a reduction in sensor detection accuracy is inevitable in the phototransistor disclosed in Patent Document 2.

The present invention was made in view of the above problems, and it is an objective of the invention to make it possible to favorably maintain the light-receiving characteristics of a phototransistor.

### SOLUTION TO THE PROBLEM

To achieve the above objective, a transparent electrode and a refresh controller are provided in the present invention to reduce a charge accumulated in a portion of a channel region, the portion facing the transparent electrode.

Specifically, the first aspect of the present invention is intended for a method of operating a phototransistor as recited in a claim 1 and a display as recited in claim 4.

Further advantageous embodiments are recited in the dependent claims.

### ADVANTAGES OF THE INVENTION

According to the present invention, a voltage is applied between a transparent electrode, and a gate electrode and a source electrode by a refresh controller, thereby reducing a charge accumulated in a portion of a channel region, the portion facing a transparent electrode. Thus, light-receiving characteristics of the phototransistor can be favorably maintained.

### BRIEF DESCRIPTION OF THE DRAWINGS

FIG. 1 is an enlarged cross-sectional view of a structure of a phototransistor in the present embodiment.
FIG. 2 is a circuit diagram showing pixels of a liquid crystal display device in the present embodiment.

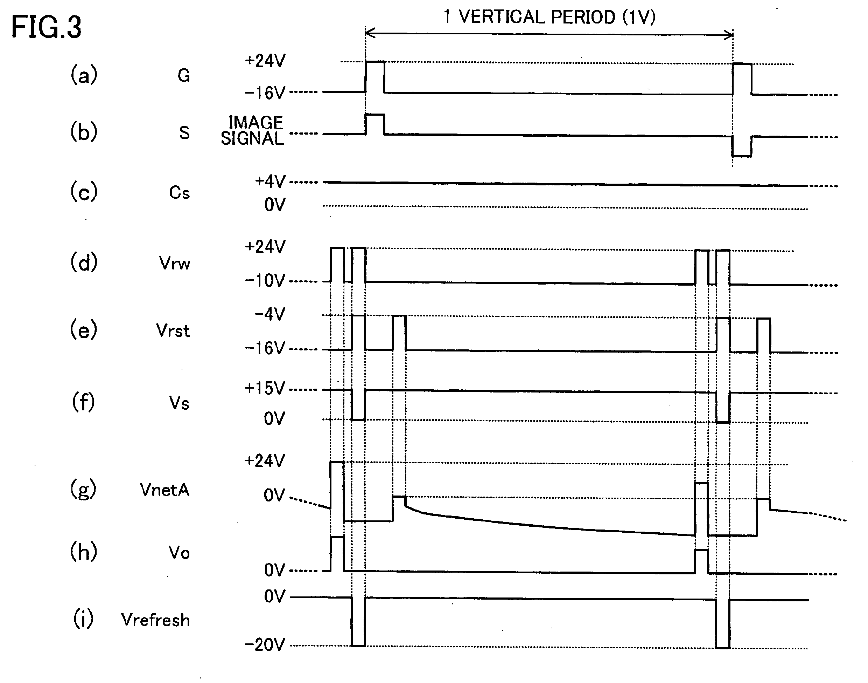

FIG. 3A is a timing chart showing a scan signal input to a gate line. FIG. 3B is a timing chart showing a simplified image signal input to a source line. FIG. 3C is a timing chart showing a signal voltage input to a capacity line. FIG. 3D is a timing chart showing a boost voltage V_{rw} input to a second line. FIG. 3E is a timing chart showing a reset voltage Vᵣₛₜ input to a first line. FIG. 3F is a timing chart showing a source voltage Vₛ input to a source line connected to an amplifier section. FIG. 3G is a timing chart showing an estimated value of a voltage V_{NetA} generated at an NetA section. FIG. 3H is a timing chart showing an output voltage Vₒ output from the amplifier section. FIG. 3I is a timing chart showing a refresh voltage V_{refresh} input to a third line.
FIG. 4 is a flowchart showing an operation of the phototransistor in the present embodiment.
FIG. 5 is a cross-sectional view schematically showing a structure of the liquid crystal display device of the present embodiment.
FIG. 6 is a graph showing a threshold characteristic of a phototransistor which had received light and deteriorated with time.
FIG. 7 is a graph showing a threshold characteristic of a phototransistor after refresh control.

### DESCRIPTION OF EMBODIMENTS

An embodiment of the present invention will be described in detail below based on the drawings. The present invention is not limited to the embodiment below.

### <<Embodiment of Invention>>

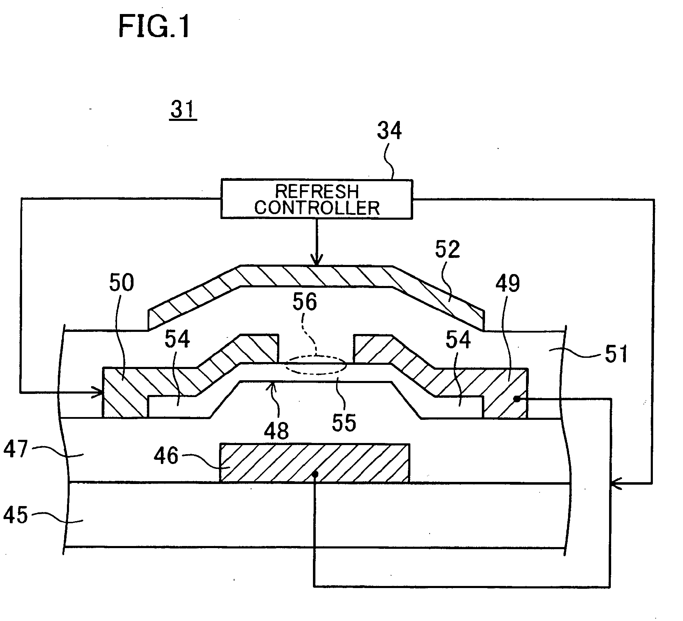

FIGS. 1-7 show an embodiment of the present invention.

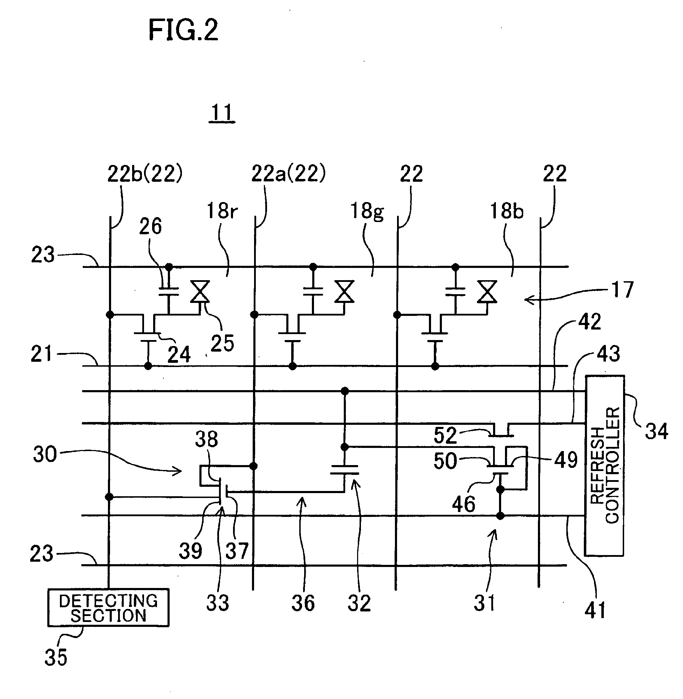

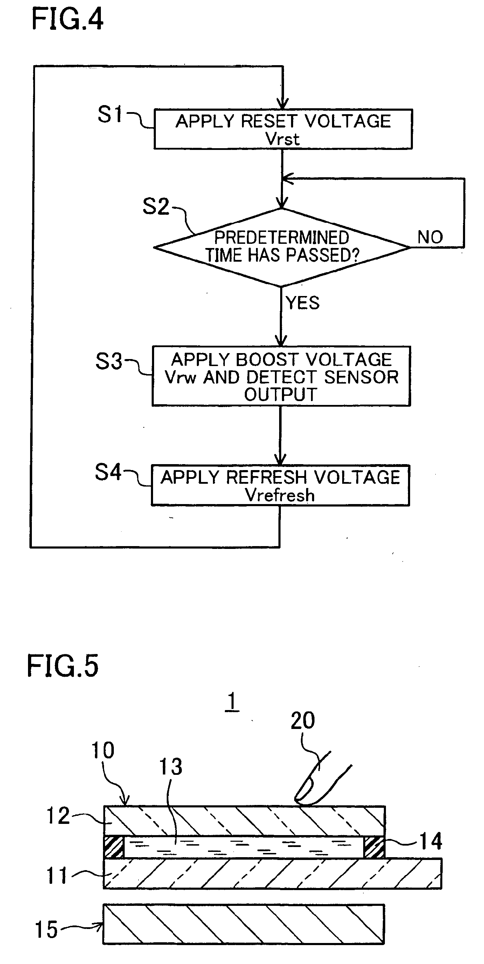

FIG. 1 is an enlarged cross-sectional view of a structure of a phototransistor 31 in the present embodiment. FIG. 2 is a circuit diagram showing pixels 17 of a liquid crystal display device 1 in the present embodiment. FIG. 3 is a timing chart for explaining an operation of a touch location detector 30. FIG. 4 is a flowchart showing an operation of the phototransistor 31 in the present embodiment. FIG. 5 is a cross-sectional view schematically showing a structure of the liquid crystal display device 1 of the present embodiment.

In the present embodiment, the liquid crystal display device 1 will be described as an example display device.

### -Structure of Liquid Crystal Display Device-

The liquid crystal display device 1 includes a liquid crystal display panel 10 and a backlight unit 15 located on the back side of the liquid crystal display panel 10 (i.e., on the side opposite to the side facing the user) as shown in FIG. 5.

The liquid crystal display panel 10 includes a TFT substrate 11 as a first substrate, and a counter substrate 12 as a second substrate opposed to the TFT substrate 11. A liquid crystal layer 13 surrounded and sealed by a frame-shaped sealing material 14 is provided between the TFT substrate 11 and the counter substrate 12. The liquid crystal layer is made of a nematic LC material, for example. The sealing material 14 is made of an epoxy resin which is cured, for example, by ultraviolet light or heat.

The counter substrate 12 includes a color filter (not shown) having pigmented layers of R, G, B, a common electrode (not shown) made of a transparent conductive film such as an ITO film, a black matrix (not shown) serving as a light-shielding layer, etc.

The liquid crystal display panel 10 includes a display region (not shown) and a frame-shaped non-display region surrounding the display region. In the display region, a plurality of pixels 17 are provided in a matrix. Each of the pixels 17 includes three picture elements 18r, 18g, 18b as shown in FIG. 2. The picture element 18r shows a red color (R); the picture element 18g shows a green color (G); and the picture element 18b shows a blue color (B). Here, a picture element is a minimum unit for displaying each color, and is also called a dot.

The TFT substrate 11 is a so-called active matrix substrate. A plurality of gate lines 21 which extend parallel to each other are provided on the TFT substrate 11, as shown in FIG. 2. Further, a plurality of source lines 22 which extend parallel to each other, and which intersect with the gate lines 21 at right angles, are also provided on the TFT substrate 11. Moreover, a plurality of capacity lines 23 each of which is located between adjacent gate lines 21, and which extend parallel to each other are provided on the TFT substrate 11.

Each of the picture elements 18r, 18g, 18b is provided, for example, in an area surrounded by adjacent source lines 22 and adjacent capacity lines 23. Each of the picture elements 18r, 18g, 18b includes a picture element electrode (not shown) for driving the liquid crystal layer 13, and a thin film transistor (TFT) 24 for driving the picture element electrode by switching. A source electrode (not shown) of the TFT 24 is connected to the source line 22. A gate electrode (not shown) of the TFT 24 is connected to the gate line 21. A drain electrode (not shown) of the TFT 24 is connected to the picture element electrode.

Each of the picture elements 18r, 18g, 18b includes a liquid crystal capacitor 25 formed between the picture element electrode and the common electrode of the counter substrate 12, and an auxiliary capacitor 26 for maintaining the liquid crystal capacity constant. The auxiliary capacitor 26 is located between the drain electrode of the TFT 24 and the capacity line 23.

In the liquid crystal display device 1, the TFT 24 is turned on by a scan signal sent to the TFT 24 through the gate line 21, and in this state, an image signal is sent to the picture element electrode through the source line 22 via the TFT 24. As a result, a desired image is displayed.

### -Structure of Touch Location Detector-

The liquid crystal display device 1 further includes a plurality of phototransistors 31, and is configured to detect, by the phototransistors 31, a touch location of an object 20, such as a finger of the user, on a display screen (a display region).

Specifically, in the liquid crystal display device 1, a touch location detector 30 for detecting a touch location of the object 20 is provided in each of the pixels 17. The touch location detector 30 includes the phototransistor 31, a capacitor section 32, and an amplifier section 33 as shown in FIG. 2.

A first line 41 which extends along the capacity line 23, and a second line 42 and a third line 43 which extend along the gate line 21 are provided on the TFT substrate 11 such that the first line 41, the second line 42, and the third line 43 pass through each of the pixels 17.

The amplifier section 33 is made, for example, of a TFT. A gate electrode 37 of the amplifier section 33 is connected to the output side of the capacitor section 32. A source electrode 38 of the amplifier section 33 is connected to one source line 22a (e.g., a source line 22a positioned at a boundary between the adjacent picture elements 18r and 18g as shown in FIG. 2). A drain electrode 39 of the amplifier section 33 is connected to a source line 22b which is positioned next to the source line 22a, and by which the picture element 18r is partitioned. A detecting section 35 for detecting an output signal of the amplifier section 33 is connected to the source line 22b.

The input side of the capacitor section 32 is connected to the second line 42 and a drain electrode 50 of the phototransistor 31.

Thus, an output value of the touch location detector 30 which corresponds to an amount of light received is detected by the detecting section 35 for each of the pixels 17. With this structure, the liquid crystal display device 1 can detect a touch location on the display screen.

### -Structure of Phototransistor-

A structure of the phototransistor 31 will be described in detail with reference to FIG. 1 and FIG. 2.

The phototransistor 31 is provided on a glass substrate 45 which is an insulating substrate forming the TFT substrate 11. The phototransistor 31 has a bottom-gate structure. That is, the phototransistor 31 includes: a gate electrode 46 formed on the glass substrate 45; a gate insulating film 47 which covers the gate electrode 46; a semiconductor layer 48 provided on a surface of the gate insulating film 47 and having a channel region 55 opposed to the gate electrode 46; a source electrode 49 and a drain electrode 50 which cover respective portions of the semiconductor layer 48; and an interlayer insulating film 51 which covers the channel region 55 of the semiconductor layer 48, the source electrode 49, and the drain electrode 50.

The gate electrode 46 is made, for example, of a light-shielding layer of a metal such as an aluminum alloy or chromium alloy. The channel region 55 of the semiconductor layer 48 is made of amorphous silicon (a-Si). Impurity areas made of n+ silicon 54 are formed in the semiconductor layer 48 on both lateral sides of the channel region 55.

A portion 56 of the channel region 55, the portion 56 facing a transparent electrode 52 (i.e., the portion of the channel region 55 indicated by dot-dot-dash line in FIG. 1), is also referred to as a back channel 56. The back channel 56 is an area of the channel region 55 which is not in contact with the gate insulating film 47, and which is also not in contact with the source electrode 49 and the drain electrode 50.

The interlayer insulating film 51 is, for example, a PAS film (i.e., a passivation film), a JAS film (i.e., an acrylic organic resin film), etc. Further, each of the source electrode 49 and the drain electrode 50 is made, for example, of a light-shielding layer of a metal such as an aluminum alloy or chromium alloy. The source electrode 49 and the gate electrode 46 have the same electric potential. Both of the source electrode 49 and the gate electrode 46 are connected to the first line 41. The source electrode 49 and the gate electrode 46 may be connected to each other, or may be made to have the same electric potential by a voltage applied through another line.

The phototransistor 31 further includes the transparent electrode 52 provided on the surface of the interlayer insulating film 51 so as to be located above the channel region 55, and includes a refresh controller 34.

The transparent electrode 52 is made, for example, of a transparent conductive film, such as an ITO film, and therefore transmits excitation light (in this case, outside light which is visible light). This transparent electrode 52 is connected to the third line 43. The interlayer insulating film 51 is preferably thin to reduce the space between the transparent electrode 52 and the back channel 56, and increase electric field effect. It is possible to provide a transparent organic insulating film, etc. for covering the transparent electrode 52.

The refresh controller 34 is connected to the first line 41, the second line 42 and the third line 43, as shown in FIG. 2. As shown in FIG. 1, the refresh controller 34 is configured to reduce a charge accumulated in the portion 56 of the channel region 55, the portion 56 facing the transparent electrode 52 (i.e., the back channel 56), by applying a voltage between the transparent electrode 52, and the gate electrode 46, the source electrode 49 and the drain electrode 50.

To reduce the charge accumulated in the back channel 56, a voltage may be applied between the transparent electrode 52, and the gate electrode 46 and the source electrode 49. However, to effectively reduce the above charge, it is preferable to apply a voltage not only to the gate electrode 46 and the source electrode 49, but also to the drain electrode 50 as described above.

Further, the refresh controller 34 is configured to apply the above voltage at every predetermined time. For example, it is preferable to apply the voltage at every vertical period.

Here, 1 vertical period (1 frame period) is a period which is needed so that a voltage is applied to the liquid crystal layer 13 of all of the pixels 17 of the liquid crystal display device 1, and one screen image is displayed on the screen.

### -Method for Detecting Touch Location-

Now, operation of the touch location detector 30 of the liquid crystal display device 1 will be described with reference to FIG. 3 and FIG. 4.

FIG. 3A is a timing chart showing a scan signal input to the gate line 21. FIG. 3B is a timing chart showing a simplified image signal input to the source line 22. FIG. 3C is a timing chart showing a signal voltage input to the capacity line 23. FIG. 3D is a timing chart showing a boost voltage V_{rw} input to the second line 42. FIG. 3E is a timing chart showing a reset voltage Vᵣₛₜ input to the first line 41.

FIG. 3F is a timing chart showing a source voltage Vₛ input to the source line 22a connected to the amplifier section 33. FIG. 3G is a timing chart showing an estimated value of a voltage V_{NetA} generated at a NetA section 36. FIG. 3H is a timing chart showing an output voltage Vₒ output from the amplifier section 33. FIG. 3I is a timing chart showing a refresh voltage V_{refresh} input to the third line 43.

A series of touch location detecting operations is performed by the touch location detector 30 at every predetermined time. In the present embodiment, a case in which the series of touch location detecting operations is performed at every vertical period will be described.

First, in step S1, the refresh controller 34 applies a reset voltage Vᵣₛₜ, for example, of -4 V to the gate electrode 46 and the source electrode 49 of the phototransistor 31 through the first line 41, as shown in FIG. 3E. The reset voltage Vᵣₛₜ is forward biased with respect to the phototransistor 31. Thus, the gate of the phototransistor 31 is turned on, and the reset voltage Vᵣₛₜ is input to the capacitor section 32 via the drain electrode 50. As a result, as shown in FIG. 3G, the voltage V_{NetA} of the NetA section 36 which is on the output side of the capacitor section 32 is reset.

Next, in step S2, it is determined whether predetermined time (1 vertical period) has passed or not. If the phototransistor 31 receives light during this 1 vertical period without being touched by an object 20, a reverse current flows to the phototransistor 31 in accordance with the amount of light received, and the voltage V_{NetA} of the NetA section 36 drops as shown in FIG. 3G. On the other hand, if light is blocked by the touch of the object 20, no reverse current flows in the phototransistor 31, and therefore, the voltage V_{NetA} of the NetA section 36 does not drop, and is maintained.

After 1 vertical period has passed, the operation goes to step S3. In step S3, the refresh controller 34 inputs a boost voltage V_{rw}, for example, of +24 V to the capacitor section 32 through the second line 42. Thus, as shown in FIG. 3D and FIG. 3G, the voltage V_{NetA} of the NetA section 36 is boosted and increased. Further, the gate of the amplifier section 33 is turned on at this time. As shown in FIG. 3H, the output voltage Vₒ corresponding to the magnitude of the boosted voltage V_{NetA} of the NetA section 36 passes through the amplifier section 33, and is detected by the detecting section 35. The state of being touched or the state of being untouched at the pixel 17 which includes the phototransistor 31 is detected based on the detected output voltage Vₒ.

Next, in step S4, the refresh controller 34 applies a refresh voltage V_{refresh}, for example, of -20 V to the transparent electrode 52 through the third line 43 as shown in FIG. 3I. As shown in FIG. 3D, a boost voltage V_{rw}, for example, of +24 V is applied at this time to the drain electrode 50 of the phototransistor 31 through the second line 42. Further, as shown in FIG. 3E, a reset voltage Vᵣₛₜ, for example, of -4 V is applied to the gate electrode 46 and the source electrode 49 of the phototransistor 31 through the first line 41. Moreover, at this time, the voltage value of the source line 22a is set to 0 V as shown in FIG. 3F.

As a result, an electric field is generated between the transparent electrode 52 having a negative electric potential and the gate electrode 46, the source electrode 49 and the drain electrode 50 each having a positive electric potential. Thus, holes gather at the back channel 56, which means that a charge (electrons) accumulated at the back channel 56 is reduced.

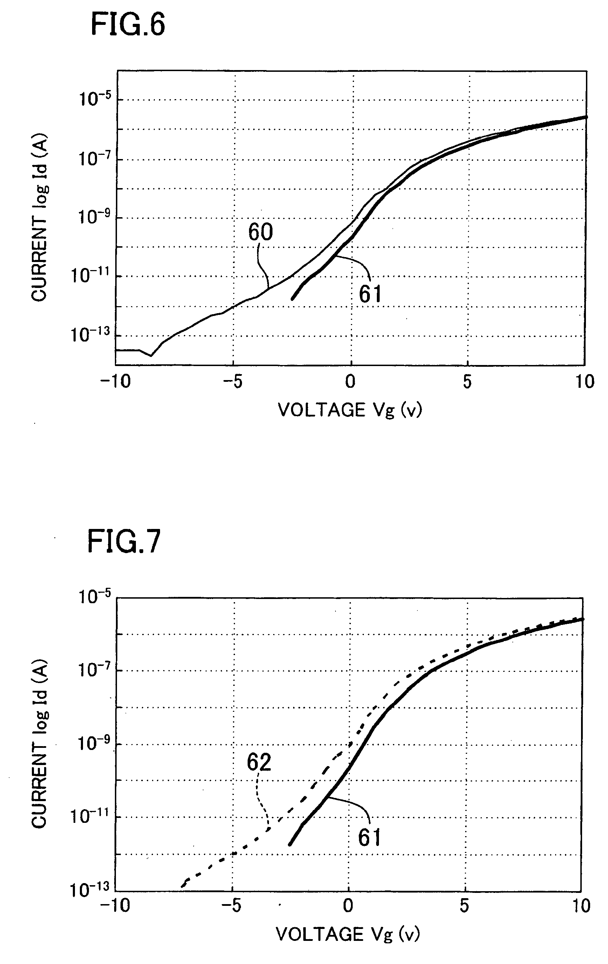

FIG. 6 is a graph showing a threshold characteristic of the phototransistor 31 which had received light and deteriorated with time. FIG. 7 is a graph showing a threshold characteristic of the phototransistor 31 after refresh control.

The graph 60 of FIG. 6 indicates a characteristic of the initial state before receiving light. On the other hand, the graph 61 of FIG. 6 indicates a characteristic of the phototransistor which continuously received light in an environment of about 10 klx. As shown in FIG. 6, if the phototransistor receives light continuously, the characteristic of the phototransistor deteriorates with time, and a threshold value Vₜₕ shifts to the direction of positive values (i.e., to the right in FIG. 6).

This may be because the amorphous silicon in the channel region received strong light, which increases the number of dangling bonds and a defect density, and as a result, carriers cannot move easily.

The graph 61 of FIG. 7 indicates a characteristic of the phototransistor 31 of the present example after receiving light. The graph 62 of FIG. 7 indicates a characteristic immediately after refresh control. As shown in FIG. 7, a threshold value Vₜₕ shifts to the direction of negative values (i.e., to the left in FIG. 7). This means that the phototransistor 31 could be brought close to the initial state.

### -Effect of First Embodiment-

According to this first embodiment, the phototransistor 31 is provided with the transparent electrode 52 and the refresh controller 34. A voltage is applied between the transparent electrode 52, and the gate electrode 46 and the source electrode 49, by the refresh controller 34, thereby making it possible to form an electric field in the back channel 56. The charge accumulated in the back channel 56 due to continuous light receiving can be reduced by this electric field. As a result, carriers in the channel region 55 can move easily, and the light-receiving characteristics of the phototransistor 31 can be brought close to the initial state. Thus, generating the electric field (i.e., performing refresh control) by this refresh controller 34 at every predetermined time can maintain favorable light-receiving characteristics of the phototransistor 31, and high sensor accuracy.

Further, the refresh control by the refresh controller 34 is performed at every vertical period. Thus, the favorable light-receiving characteristics of the phototransistor 31 can be maintained for each one screen image display.

Further, the electrode provided above the back channel 56 is the transparent electrode 52 which transmits outside light (excitation light). Thus, it is possible to generate an electric field in the back channel 56 without impairing the function of the phototransistor 31 as an optical sensor.

Further, since a voltage is applied not only between the transparent electrode 52, and the gate electrode 46 and the source electrode 49, but also between the transparent electrode 52 and the drain electrode 50, the charge accumulated in the back channel 56 can be more effectively reduced.

Further, since the voltage value of the source line 22a is set to 0 V during the refresh control as shown in FIG. 3F, it is possible to prevent a significantly boosted voltage from being applied to the detecting section 35 or other driver circuits through the source line 22b. As a result, circuits such as the detecting section 35 can be protected.

### «Another Embodiment»

The liquid crystal display device 1 was described in the above embodiment. However, the present invention is not limited to the liquid crystal display device 1, and can also be applied to display devices such as an organic EL display device.

### INDUSTRIAL APPLICABILITY

As described above, the present invention is useful as a phototransistor and a display device having the phototransistor.

### DESCRIPTION OF REFERENCE CHARACTERS

- 1: liquid crystal display device
- 20: object
- 30: touch location detector
- 31: phototransistor
- 32: capacitor section
- 33: amplifier section
- 34: refresh controller
- 35: detecting section
- 36: NetA section
- 41: first line
- 42: second line
- 43: third line
- 45: glass substrate (insulating substrate)
- 46: gate electrode
- 47: gate insulating film
- 48: semiconductor layer
- 49: source electrode
- 50: drain electrode
- 51: interlayer insulating film
- 52: transparent electrode
- 55: channel region
- 56: back channel (a portion of channel region, the portion facing a transparent electrode)

## Claims

1. A method of operating a phototransistor (31),
comprising:
a gate electrode (46) formed on an insulating substrate (45);
a gate insulating film (47) which covers the gate electrode (46);
a semiconductor layer (48) which is formed on a surface of the gate insulating film (47), and has a channel region (55) opposed to the gate electrode (46);
a source electrode (49) and a drain electrode (50) which cover respective portions of the semiconductor layer (48); and
an interlayer insulating film (51) which covers the channel region (55) of the semiconductor layer (48), the source electrode (49) and the drain electrode (50), wherein
the source electrode (49) and the gate electrode (46) have the same electric potential, and
the phototransistor (31) includes
a transparent electrode (52) formed on a surface of the interlayer insulating film (51) so as to overlap the channel region (55),
a portion (56) of the channel region (55) facing the transparent electrode, and **characterised by**
a refresh controller (34) for reducing a charge accumulated in said portion (56) of the channel region (55) by applying a voltage between the transparent electrode (52) on the one hand and the gate electrode (46) and the source electrode (49) on the other hand.

2. The method of operating a phototransistor (31) of claim 1,
wherein the refresh controller (34) is configured to apply the voltage between the transparent electrode (52), and the gate electrode (46), the source electrode (49) and the drain electrode (50) to reduce the charge.

3. The method of operating a phototransistor (31) of claim 1 or 2,
wherein the refresh controller (34) is configured to apply the voltage at every predetermined time.

4. A display device (1),
comprising a plurality of phototransistors (31) by which a location touched by an object on a display screen (10) is detected,
wherein each of the phototransistors (1) is operated according to any of claims 1 to 3.

5. The display device (1) of claim 4,
wherein the refresh controller (34) is configured to apply the voltage at every vertical period.

## Patentansprüche

1. Verfahren zum Betreiben eines Fototransistors (31),
mit:
einer Gateelektrode (46), die auf einem isolierenden Substrat (45) ausgebildet ist,
einer Gateisolationsschicht (47), welche die Gateelektrode (46) bedeckt,
einer Halbleiterschicht (48), welche auf einer Oberfläche der Gateisolationsschicht (47) ausgebildet ist und welche ein Kanalgebiet (55) der Gateelektrode (46) gegenüberliegend aufweist,
einer Sourcelektrode (40) und einer Drainelektrode (50), welche jeweilige Bereiche der Halbleiterschicht (48) bedecken, und
einer Zwischenisolationsschicht (51), welche das Kanalgebiet (45) der Halbleiterschicht (48), die Sourceelektrode (49) und die Drainelektrode (50) bedeckt,
wobei
die Sourceelektrode (49) und die Gateelektrode (46) dasselbe elektrische Potential besitzen, und
der Fototransistor (31) aufweist
eine transparente Elektrode (52), die auf einer Oberfläche der Zwischenisolationsschicht (51) so ausgebildet ist, um mit dem Kanalbereich (55) zu überlappen,
ein Bereich (56) des Kanalgebiets (55), welcher an die transparente Elektrode angrenzt, und
**gekennzeichnet ist durch**
eine Refresh-Steuerung (34) zum Reduzieren einer im Bereich (56) des Kanalsgebiets (55) akkumulierten Ladung **durch** Anlegen einer Spannung zwischen der transparenten Elektrode (52) einerseits und der Gateelektrode (46) und der Sourceelektrode (49) andererseits.

2. Verfahren zum Betreiben eines Fototransistors (31) nach Anspruch 1,
wobei die Refresh-Steuerung (34) ausgebildet ist, die Spannung zwischen der transparenten Elektrode (52) und der Gateelektrode (46), der Sourceelektrode (59) und der Drainelektrode (50) anzulegen, um die Ladung zu reduzieren.

3. Verfahren zum Betreiben eines Fototransistors (31) nach Anspruch 1 oder 2,
wobei die Refresh-Steuerung (34) ausgebildet ist, die Spannung zu jeder bestimmten Zeit anzulegen.

4. Anzeigeeinrichtung (1),
mit einer Mehrzahl von Fototransistoren (31), durch welche eine Stelle, die durch eine Person berührt wird, auf einem Anzeigeschirm (10) detektiert wird,
wobei jeder der Fototransistoren (1) nach einem der Ansprüche 1 bis 3 betrieben wird.

5. Anzeigeeinrichtung (1) nach Anspruch 4,
wobei die Refresh-Steuerung (34) ausgebildet ist, die Spannung zu jeder vertikalen Periode anzulegen.

## Revendications

1. Procédé de fonctionnement d'un phototransistor (31) comprenant :
une électrode de grille (46) formée sur un substrat isolant (45) ;
un film isolant de grille (47) qui couvre l'électrode de grille (46) ;
une couche semi-conductrice (48) qui est formée sur une surface du film isolant de grille (47) et qui présente une zone formant canal (55) opposée à l'électrode de grille (46) ;
une électrode de source (49) et une électrode de drain (50) qui couvrent des parties respectives de la couche semi-conductrice (48) ; et
un film isolant intermédiaire (51) qui couvre la zone formant canal (55) de la couche semi-conductrice (48), l'électrode de source (49) et l'électrode de drain (50),
étant précisé
que l'électrode de source (49) et l'électrode de grille (46) ont le même potentiel électrique, et
que le phototransistor (31) contient
une électrode transparente (52) formée sur une surface du film isolant intermédiaire (51) de manière à recouvrir la zone de canal (55),
une partie (56) de la zone de canal (55) qui fait face à l'électrode transparente, et **caractérisé par**
un régulateur de rafraîchissement (34) pour réduire une charge accumulée dans ladite partie (56) de la zone de canal (55) en appliquant une tension entre l'électrode transparente (52), d'une part, et l'électrode de grille (46) et l'électrode de source (49), d'autre part.

2. Procédé de fonctionnement d'un phototransistor (31) de la revendication 1,
étant précisé que le régulateur de rafraîchissement (34) est conçu pour appliquer la tension entre l'électrode transparente (52), et l'électrode de grille (46), l'électrode de source (49) et l'électrode de drain (50) pour réduire la charge.

3. Procédé de fonctionnement d'un phototransistor (31) de la revendication 1 ou 2,
étant précisé que le régulateur de rafraîchissement (34) est conçu pour appliquer la tension à chaque moment prédéterminé.

4. Dispositif d'affichage (1),
comprenant plusieurs phototransistors (31) par lesquels un endroit touché par un objet sur un écran d'affichage (10) est détecté,
étant précisé que chacun des phototransistors (1) fonctionne selon l'une quelconque des revendications 1 à 3.

5. Dispositif d'affichage (1) de la revendication 4, étant précisé que le régulateur de rafraîchissement (34) est conçu pour appliquer la tension à chaque période verticale.
